Europäisches Patentamt

European Patent Office

Office européen des brevets

(11) Publication number: **0 477 981 A2**

# EUROPEAN PATENT APPLICATION

(21) Application number: **91116579.3**

(22) Date of filing: **27.09.91**

(51) Int. Cl.⁵: **H05K 1/00**, H05K 3/46, H05K 3/00

(30) Priority: **27.09.90 JP 258377/90**
**27.09.90 JP 258379/90**

(43) Date of publication of application:
**01.04.92 Bulletin 92/14**

(84) Designated Contracting States:
**DE FR**

(71) Applicant: **TOSHIBA LIGHTING &**
**TECHNOLOGY CORPORATION**
**4-28, Mita 1-Chome**
**Minato-Ku Tokyo-To(JP)**

(72) Inventor: **Takeuchi, Megumu**
**2007-27-105, Kamikurata-Cho, Totsuka-Ku**
**Yokohama-Shi, Kanagawa-Ken(JP)**
Inventor: **Uchino, Katsusuke**
**298-8, Takada-Cho, Kohoku-Ku**
**Yokohama-Shi, Kanagawa-Ken(JP)**

(74) Representative: **Münzhuber, Robert,**
**Dipl.-Phys. et al**
**c/o BOEHMERT & BOEHMERT**
**Rumfordstrasse 10**
**W-8000 München 5(DE)**

(54) **Multi-layer circuit substrate having a non-planar shape, and a method for the manufacture thereof.**

(57) A multi-layer circuit substrate is formed as a planar shape by the monolithic lamination of a plural number of film substrates that have had conductive patterns (21, 31) of a required shape formed by a conductive paste that has a thermoplastic resin as the binder, being applied to a surface of an insulation film comprising a thermoplastic resin, and furthermore, has a non-planar shape (22, 32) produced by making a required non-planar portion at a bend portion or a curve portion. Furthermore, the conductive pattern (21, 31) is provided with a reinforcing portion that increases the sectional area and strength of a place where a non-planar surface portion is formed in the multi-layer circuit substrate, so that it is stronger than other portions. In addition, a multi-layer circuit substrate that has a non-planar surface shape of a bent portion or a curved portion is formed from a step for the formation of a conductive pattern having a film substrate by forming a reinforced portion (22, 32) that strengthens a pattern of a portion given a non-planar shape (22, 32) in a later process, so that it is stronger than other portions; a step for laminating a plural number of film substrates that have had conductive patterns (21, 31) formed in a prior step, positioning the patterns so that they are in agreement, and forming a planar-shaped multi-layer circuit substrate that is made monolithic by thermal adhesion, and for forming a monolithic planar-shaped multi-layer substrate by thermal adhesion; and after positioning the reinforcing portion (23, 33) of the planar-shaped multi-layer substrate so that it is in agreement with a place for the formation of a non-planar shape(22, 32), a step for applying a constant working force to form a required non-planar shape.

FIG. 4

## BACKGROUND OF THE INVENTION

The present invention relates to multi-layer circuit substrates having a non-planar shape, and in particular to multi-layer circuit substrates that have a non-planar portion such as a curve and/or a bent portion in addition to a planar portion, and that are of the high-density mounting type.

In recent years, along with more compact, lightweight and thin electronic apparatus, there has been a growing demand for the control circuit devices used in such electronic apparatus to also be more compact, lightweight and thin. These control circuit devices have semiconductor and other electronic parts and the like mounted to a semiconductor on a substrate having a conductive pattern and so making them more compact, lightweight and thin involves making both the substrate and the control parts such as the semiconductors more compact.

The substrates used in this type of control circuit device are glass-epoxy substrates that are a mixture of glass to an epoxy type resin and have metal plating of a conductive pattern implemented to the surface, or flexible print circuit (FPC) substrates that has an attached circuit pattern of either metal film or an electroconductive layer that includes either a conductive paste in a resin such as polyester or polyamide and the like.

However, it is necessary for glass-epoxy substrates to have complex plating processing, and the conventionally type of FPC substrate has the problem of it being difficult to have high-density wiring because of there being only one layer.

In order to solve these problems, development is progressing for a multi-layer type of circuit substrate of the high-density mounting type wherein a conductive pattern is formed on a resin substrate having the shape of a film and this film is then laid in multiple layers on the substrate.

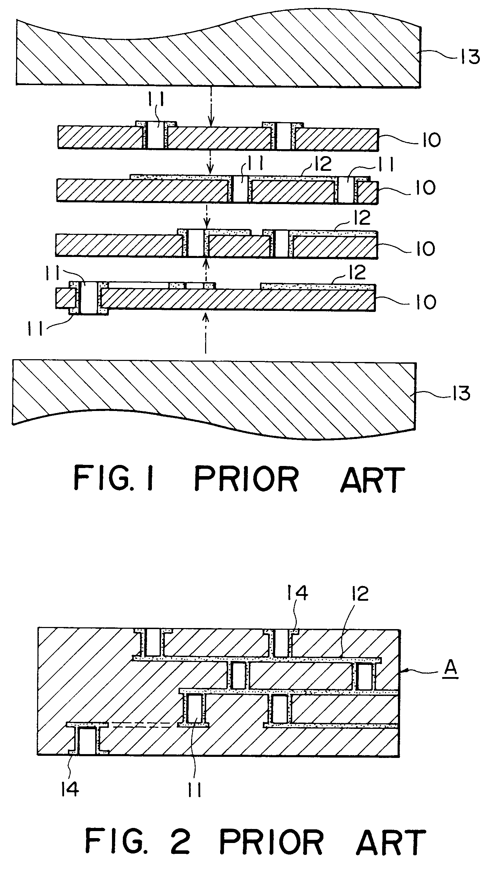

Such multi-layer circuit substrates are generally as shown in FIG. 1, and are manufactured by the method described below, for example.

First, a heat-deformable film substrate 10 is provided by a thermo-plastic resin such as polycarbonate, polysulfone, polyacrylate or the like, and at the required places of this film substrate 10 are formed through holes 11, and a conductive pattern 12 is then screen printed to the surface of this substrate 10 using a conductive paste that has a thickness of 20 $\mu$m.

This film substrate 10 is then folded into a plural number of layers and the positions of the through holes 11 and the conductive pattern 12 are adjusted and inserted between the plates 13 and 13 of a heat press so that the unifying thermal adhesion of the film substrate 10 due to the conductive pattern by the plates 13 and 13 of the heat press forms the multi-layer circuit substrate A such as that shown in FIG. 2.

Moreover, the numerals 14 and 14 represent electrodes that are formed on the front and rear surfaces of the substrate.

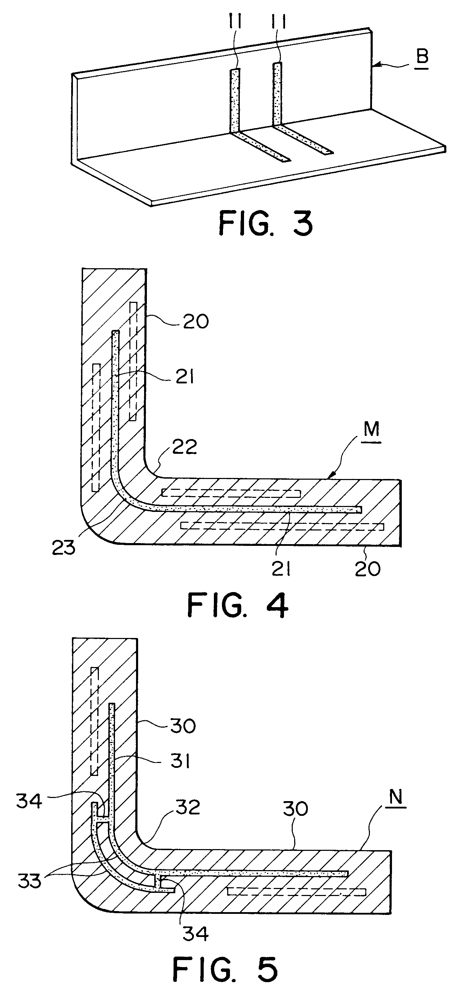

This multi-layer circuit substrate A can be used as it is but as shown in FIG. 3, when electronic parts (not shown in the figure) are manufactured, a multi-layer circuit substrate B that has been bent at a constant angle such as a right angle, must be used.

This bent multi-layer circuit substrate B is formed by bending a flat multi-layer circuit substrate A and so the conductive pattern formed by the conductive paste is also bent along with the thermoplastic conductive film. In particular, large bending stresses are applied with respect to the conductive pattern that intersects the non-planar portion such as the bent portion for example, and this causes cracks to generate in the conductive pattern at this portion and in the worst case, involves the problem of the conductive pattern breaking to the detriment of the reliability as a product.

## SUMMARY OF THE INVENTION

An object of the present invention is to provide a multi-layer circuit substrate that can prevent the generation of breaks or the generation of cracks in the electroconductive pattern in a non-planar portion such as a curve or a bent portion for example, irrespective of the processes of manufacture of the multi-layer circuit substrate and the amount of time in use.

In addition, another object of the present invention is the provision of a method for the manufacture of a multi-layer circuit substrate that has no application of bending or pressure stress to the conductive pattern when the non-planar portion is formed by bending or pressing after the formation of the flat substrate, and no generation of breaks and cracks in the conductive pattern positioned at this non-planar portion.

In order to attain these objects, the multi-layer circuit substrate and having a non-planar shape and relating to the present invention is a multi-layer circuit substrate formed so as to include a film substrate comprising a film comprising thermoplastic resin, a conductive pattern that is formed on this film by a conductive paste comprising a thermoplastic resin binder, and this film substrate is laminated and subjected to thermal adhesion so that it is formed into a unit and so that the entirety includes a flat portion and a portion other than this flat portion, and wherein the conductive pattern has a reinforced portion that has a physical strength (stress) with respect to the external forces of bending and curves at a portion positioned on the non-planar portion. The specific configuration of this reinforcing portion can be such that the thickness of the conductive pattern positioned at the non-planar portion is greater than the film thickness of the conductive pattern positioned at portions other than the non-planar portion, or it can be configured so that the conductive pattern that crosses the non-planar portion and particularly the bent portion is inclined with respect to the line of bending.

Furthermore, the multi-layer circuit substrate relating to the present invention has a multi-layer bridge structure for the conductive patterns which intersect the bent portion.

In a multi-layer circuit substrate having the configuration described above, the conductive pattern is screen printed to a greater thickness at the bent portion and so even if cracks do form in the non-planar substrate when the multi-layer circuit substrate is bent, it is still possible to have fewer problems such as breaks in the conductive pattern at these bent portions. In addition, when there is a multi-layer bridge structure for the conductive pattern, then even if cracks form in the conductive pattern due to deformation due to bending, it is still possible to greatly reduce the faults such as breaks since the conductive pattern has a multi-layered bridge structure.

The multi-layer circuit substrate relating to the present invention has an electroconductive pattern formed by a conductive paste using a thermoplastic resin as the binder on a film comprising a thermoplastic resin and this film substrate is then laminated and subjected to thermal adhesion to become a monolithic multi-layer circuit substrate, and a bent portion is then formed in this multi-layer circuit substrate and the thickness of a conductive pattern at this bent portion is thicker than the thickness at other portions and so even if large bending stresses for example, are received, and there is the generation of cracks in the conductive pattern, it is still possible to greatly reduce the generation of faults such as breaks in the conductive pattern of the multi-layer circuit substrate. In addition, when the conductive pattern of the multi-layer circuit substrate have a multi-layer bridge structure, then there is an extremely small possibility of breaks in the plural number of conductive patterns that configure the multi-layer bridge occurring at the same time even if there is the generation of cracks in the conductive pattern due to the deformation that occurs with bending and so it is possible to greatly reduce the number of faults due to breaks.

In addition, the method for the manufacture of a multi-layer circuit substrate having a non-planar portion and in order to achieve the invention described above, comprises a process for the multi-layer lamination to a predetermined portion of a conductive pattern formed with a reinforcing portion by a conductive paste comprising a thermoplastic resin binder, on a film comprising a thermoplastic resin, a process for the monolithic formation of a film substrate through the thermal adhesion of a pattern and a film in a plural number of laminated layers, and a process for giving a required and constant shape to a portion to which working forces of thermal adhesion and the like are applied and to where the reinforcing portion is positioned.

In the process for the formation of a conductive pattern positioned in a non-planar portion such as a given curved or a bent portion and which is the last process in the manufacture of a multi-layer circuit substrate using the processes such as those described above, the formation of a portion positioned in the non-planar portion so as to physically strengthen that portion so that it is stronger than the portion equivalent to the planar portion forms a conductive pattern having the same thickness as the conductive pattern positioned in the planar portion even if there is tension and contraction to a greater extent than the planar portion in the processes where the bent or curved shape is formed, and thus provides a sufficient physical strength (stress) with respect to external forces (loads) such as bending and curvature.

BRIEF DESCRIPTION OF THE DRAWINGS

In the appended figures,

FIG. 1 is a sectional view that describes the manufacturing method of a general multi-layer circuit substrate of the high-density mounting type and that has a planar shape;

FIG. 2 is a sectional view that describes the manufacturing method of a multi-layer circuit substrate manufactured by the method shown in FIG. 1;

FIG. 3 is a perspective view describing a conventional multi-layer circuit substrate having a non-planar portion formed from a curve;

FIG. 4 is a sectional view that describes a multi-layer circuit substrate having a non-planar portion formed from a curve and according to a first embodiment of the present invention;

FIG. 5 is a sectional view that describes a multi-layer circuit substrate having a non-planar portion formed from a curve and according to a second embodiment of the present invention;

FIG. 6 is a perspective view that describes a multi-layer circuit substrate having a non-planar portion formed from a curve and according to a third embodiment of the present invention; and

FIG. 7 is an enlarged perspective view of a curved portion of a multi-layer circuit substrate according to a third embodiment of the present invention as shown in FIG. 6.

DETAILED DESCRIPTION OF THE PREFERRED EMBODIMENTS

The following is a detailed description of preferred embodiments of the multi-layer circuit substrate having a non-planar shape and relating to the present invention, with reference to the appended figures.

The multi-layer circuit substrate according to a first embodiment of the present invention is shown in more detail in FIG. 4. The multi-layer circuit substrate M having a curved portion and shown in FIG. 4 is manufactured by fundamentally the same method as the conventional multi-layer circuit substrate B having a bent portion and shown in FIG. 2 through FIG. 3. Accordingly, a duplicate detailed description is omitted here.

The multi-layer circuit substrate M according to this first embodiment is also provided with through holes at required places on a film substrate comprising a thermoplastic resin, and is formed by a conductive pattern 21 formed by screen printing a conductive past having a thickness of 20 $\mu$m for example, to a planar portion 20 which is a portion other than a curved portion of a film substrate.

In particular, screen printing is performed when the thickness of a conductive pattern 23 formed at a bent portion 22 of a multi-layer circuit substrate relating to a first embodiment is about 10 $\mu$m thicker than the conductive pattern 21 of the planar portion 20.

A plural number of layers of the film substrate are overlaid and subjected to thermal adhesion and bent by a being machine to form the multi-layer circuit substrate M which is bent at a right angle, for example. When this is done, the conductive pattern 23 of the bent portion 22 is set so that it is thicker than the conductive pattern 21 of the planar portion 20 and so even if large bending stresses are applied when the bending processing is implemented, there is no generation of cracks or breaks in the conductive pattern 23.

The following is a detailed description of a second embodiment of the multi-layer circuit substrate having a non-planar shape and relating to the present invention, with reference to FIG. 5. The multi-layer circuit substrate N relating to a second embodiment is also formed with many through holes at required places on a film substrate comprising a thermoplastic resin, and a conductive pattern with a thickness of about 20 $\mu$m is screen printed to the multi-layer circuit substrate of the planar portion 30.

Here, in this second embodiment, the conductive pattern branches via the through holes 34 and is also formed on the other film substrates so that the conductive pattern 31 that intersects the bent portion 32 configures circuits that are electrically parallel with the conductive pattern that is formed on the other laminated film substrates. In other words, there conductive pattern that intersects the bent portions has a multi-layer bridge structure.

If a configuration such as this is used, then the conductive pattern at the bent portion form a multi-layer bridge structure when the multi-layer circuit substrate N is subjected to bending processing by a bending machine or the like, and so there is no generation of electrical breaks i the conductive pattern because of this multi-layered bridge structure, even if cracking or the like occurs in the conductive pattern due to deformation of the film substrate due to bending processing.

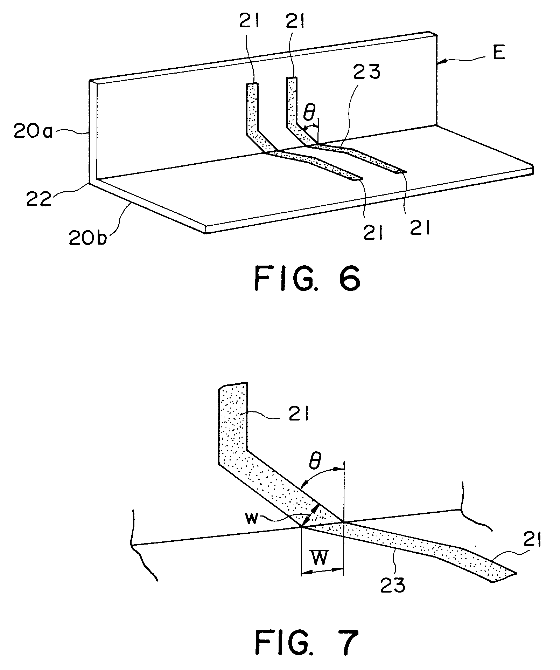

The following is a description of a multi-layer circuit substrate relating to a third embodiment of the present invention, with reference to FIG. 6 and the enlarged view shown in FIG. 7.

The multi-layer circuit substrate E shown in FIG. 6 is provided with many through holes at required places on a film substrate comprising a thermoplastic resin, and a conductive pattern 21 with a thickness of about 20 $\mu$m for example, is screen printed to the planar surfaces 20a and 20b which are places other than the non-planar portions 22 of the curved portion and the like of the film substrate. In addition, this conductive pattern 21 is formed beforehand so as to intersect the line of bending of the bent portion 22 at an angle. If formed in this manner, the portion of the pattern that intersects at an angle has a sufficiently greater physical strength than the linear pattern formed when the patterns intersect at right angles for example, and so the bent portion 22 that intersects the line of bending at an angle in this embodiment, functions as a reinforced portion.

Here, as shown in FIG. 7, when the angle of inclination of the line of bending in this bent portion 22 is 30 degrees, the width w of the conductive pattern that intersects the bent portion is increased by approximately 15% so that the width of the pattern becomes W at the bent portion.

The following is a description of the manufacturing process of a multi-layer circuit substrate according to this third embodiment. First, a plural number of film substrates on which the patterns have been screen printed are readied, and the positions of the points of connection of the patterns of each of the substrates are adjusted so as to be in agreement and the substrates are laminated.

After this, the plural number of circuit substrates that have been laminated are positioned between the plates of a heat press and heat and pressure applied from both sides to form a single planar, multi-layer circuit substrate. The status of the conductive pattern at this time is of course such that the wiring pattern is formed in accordance with the function of the device that is to be configured by the multi-layer circuit substrate but in addition, the portion of the conductive pattern that intersects a portion where a bent portion is to be formed as a non-planar portion is formed at a constant angle of inclination with respect to a protruding distal end surface of a bend portion or a curved portion, so as to form a reinforced portion that strengthens this portion with respect to stresses due to external forces applied during the bending processing and after completion of the product.

Furthermore, the planar-shaped multi-layer circuit substrate formed with a reinforced portion in this manner forms a multi-layer circuit substrate is set in a bending machine or the like and a bent portion is formed. The bent multi-layer circuit substrate is bent along the side of one surface of the front and rear sides but the portion where the pattern is stretched is the side of the outer surface of the bend and so the portion of the conductive pattern on the side of the inner surface can be formed so as to intersect the line of bending at right angles and so as to not have a reinforced portion formed.

In this manner, a substrate that is formed with a conductive pattern formed at an angle with respect to a line of bending can have an increased sectional area of bending of the conductive pattern that crosses the portion inclined at an angle, and so stress with respect to the influence of cracks and the like can be increased by the amount that this sectional area is increased and the amount of failures such as breaks reduced.

**Claims**

1. A method of the manufacture of a multi-layer circuit substrate [B,E,M,N] having a non-planar shape and comprising:

    a step for the formation of a conductive pattern (21, 31) having a film substrate by forming a reinforced portion (23, 33) that strengthens a pattern of a portion given a non-planar shape (22, 32) in a later process, so that it is stronger than other portions;

    a step for laminating a plural number of film substrates that have had conductive patterns (21) formed in a prior step, positioning said patterns so that they are in agreement, and forming a planar-shaped multi-layer circuit substrate (B,E,M,N) that is made monolithic by thermal adhesion, and for forming a monolithic planar-shaped multi-layer substrate by thermal adhesion; and

    after positioning said reinforcing portion (23, 33) of said planar-shaped multi-layer substrate so that it is in agreement with a place for the formation of a non-planar shape(22, 32) , a step for applying a constant working force to form a required non-planar shape.

2. The method of manufacture of a multi-layer circuit substrate of claim 1, wherein:

    in a step for forming said non-planar shape, a non-planar shape formed in a planar-shaped multi-layer circuit substrate is a bent portion (22) that curves a planar shape into an L-shaped bend.

3. The method of manufacture of a multi-layer circuit substrate of claim 2, wherein:

    in a step for the formation of said film substrate, said pattern at a portion of said planar substrate and that has been given a bend has a greater thickness than other portions and forms a conductive pattern on a surface of said insulation film so that said portion having a greater thickness becomes said reinforcing portion (23, 33).

4. The method of manufacture of a multi-layer circuit substrate of claim 3, wherein:

    in a step for the formation of said film substrate, when said laminated film substrate is bent in a later process, a thick film portion on the substrate that will be positioned on the outer side, has a different lamination position so that the layer thickness will become larger than a thick film portion on the substrate that will be positioned on the inner side.

5. The method of manufacture of a multi-layer circuit substrate of claim 2, wherein:

    in a step for the formation of said film substrate, when a portion that has been given a bend in said substrate is bent in a later process, said pattern becomes a portion that is inclined with respect to a line of bending and a conductive pattern (21, 31) is formed in a surface of said insulation film so that this inclined portion becomes said reinforcing portion.

6. The method of manufacture of a multi-layer circuit substrate of claim 1, wherein:

    in a step for forming said non-planar shape, a non-planar surface shape given to a multi-layer circuit substrate having a planar shape curves a specific portion of a plane into a curve so that it protrudes gently into a side surface.

7. The method of manufacture of a multi-layer circuit substrate of claim 6, wherein:

    in a step for the formation of said film substrate, said pattern at a portion of said planar substrate and that has been given a curve has a greater thickness than other portions and forms a conductive pattern (21, 31) on a surface of said insulation film so that said portion having a greater thickness becomes said reinforcing portion.

8. The method of manufacture of a multi-layer circuit substrate of claim 7, wherein:

in a step for the formation of said film substrate, when a specific portion of a laminated film substrate is made to protrude in a later process, a thick film portion on the substrate that will be positioned on the outer side, has a different lamination position so that the layer thickness will become larger than a thick film portion on the substrate that will be positioned on the inner side.

9. The method of manufacture of a multi-layer circuit substrate of claim 8, wherein:

said thick film portion is formed so as to have a greater thickness on an inner side than on an outer side of a curve, for the side that is on the base side of said curved portion.

10. A multi-layer circuit substrate that has a plural number of film substrates on which a conductive pattern (21, 31) has been formed on an insulation film comprising a thermoplastic resin by a conductive past that has a thermoplastic resin as the binder, monolithically laminated and a non-planar surface formed by giving a required non-planar portion (22, 32), wherein:

said conductive pattern (21, 31) is provided with a reinforcing portion (23, 33) that increases a sectional area and a strength of a place where said non-planar portion (22, 32) of said multi-layer circuit substrate is formed, so that it is greater than that of other portions.

11. The multi-layer circuit substrate of claim 10, wherein:

a non-planar shape given (22, 32) to said multi-layer circuit substrate is a bent portion that bends said plane into an L-shape, and

said conductive pattern (21, 31) has a reinforcing portion where a film thickness at a bent portion (23, 33) of said substrate is greater than a film thickness at other portions.

12. The multi-layer circuit substrate of claim 11, wherein:

said conductive pattern (21, 31) has a reinforcing portion formed so that layers of a bent portion of said substrate are formed so as to become progressively thicker from the inner side to the outer side.

13. The multi-layer circuit substrate of claim 10, wherein:

a non-planar shape given to said multi-layer circuit substrate is a bent portion that bends said plane into an L-shape, and

said conductive pattern has a reinforcing portion (23, 33) that is formed so that a sectional area of said pattern in said bent portion that crosses a line of bending of a bent portion (22, 32) of said substrate at an angle, is greater.

14. The multi-layer circuit substrate of claim 10, wherein:

a non-planar surface shape (22, 32) given to a multi-layer circuit substrate is a curved shape that has a curved portion protruding gently into a specific portion of a plane, and

said conductive pattern is provided with a reinforcing portion that is formed across the width of said curved portion.

FIG. I   PRIOR   ART

FIG. 2   PRIOR   ART

FIG. 3

FIG. 4

FIG. 5

FIG. 6

FIG. 7